Europäisches Patentamt

European Patent Office

Office européen des brevets

(11) Veröffentlichungsnummer: **0 054 211**
**A2**

(12) **EUROPÄISCHE PATENTANMELDUNG**

(21) Anmeldenummer: 81109994.4

(22) Anmeldetag: 28.11.81

(51) Int. Cl.³: **H 05 K 1/18**

(30) Priorität: 06.12.80 DE 3046041

(43) Veröffentlichungstag der Anmeldung:
23.06.82 Patentblatt 82/25

(84) Benannte Vertragsstaaten:
AT BE CH DE FR GB IT LI LU NL SE

(71) Anmelder: Stettner & Co.
Hersbrucker Strasse 22
D-8560 Lauf(DE)

(72) Erfinder: Horstmann, Jürgen
Richard-Wagner-Strasse 21
D-8560 Lauf(DE)

(74) Vertreter: Patentanwälte Czowalla . Matschkur +
Partner
Königstrasse 1
D-8500 Nürnberg(DE)

(54) Schaltungsplatte aus verformbarem Material.

㊹ Schaltungsplatte aus verformbarem Material, insbesondere aus Hartpapier oder faserverstärktem organischem Kunststoff, mit wenigstens einem rechteckigen Steckschlitz (2) zum Einstecken und klemmenden Halten von plättchenförmigen Bauelementen (3) mit schrägen Einsteckkanten an den Schmalseiten (5), wobei die Länge (12) des Steckschlitzes (2) etwas größer ist als die Breite (13) des Bauelementes (3) bzw. die Breite (13) des Bauelementes (3) im Steckbereich (4) und die Steckschlitzbreite (14) 0,2 bis 0,8 mm, insbesondere 0,3 bis 0,6 mm größer ist als die Dicke (15) des Bauelementes (3) bzw. seines Steckbereichs (4), und im Bereich der Schlitzenden (10,11) an beiden Längsseiten (16,17) an gegenüberliegenden Stellen nach innen ragende Zungen (18, 19) vorgesehen sind, deren lichte Weite (20) 0,05 bis 0,4 mm, insbesondere 0,1 bis 0,3 mm kleiner ist als die Dicke (15) des Bauelementes (3) bzw. seines Steckbereichs (4) und wobei die Zungen (18, 19) im Bereich der schrägen Einsteckkanten (5) derart angeordnet sind, daß sie erst ab einer bestimmten Einsetztiefe (23) des Bauelementes (3) mit diesem in Wirkverbindung treten können.

FIG. 1

EP 0 054 211 A2

Schaltungsplatte aus verformbarem Material
------------------------------------------------

Die vorliegende Erfindung bezieht sich auf eine Schaltungsplatte aus verformbarem Material, insbesondere aus Hartpapier oder faserverstärktem organischem Kunststoff, mit wenigstens einem rechteckigen Steckschlitz zum Einstecken und klemmenden Halten von plättchenförmigen Bauelementen mit schrägen Einsteckkanten an den Schmalseiten.

Bei den bekannten Schlitzformen ist die Schlitzbreite wesentlich größer als die Dicke des Bauelementes und im mittleren Bereich ist der Schlitz so schmal, daß die lichte Weite an der engsten Stelle kleiner ist als die Bauelementdicke. Ein eingestecktes plättchenförmiges Bauelement wird hierbei durch die vorspringende Stirnkante der Längsseiten des Schlitzes in seiner Lage fixiert. Beim Einstecken der Bauelemente selbst treffen diese mit ihrer geraden Unterkante zunächst auf die Oberfläche der vorspringenden Längsseiten. Bei einem bestimmten Einsteckdruck geben die Vorsprünge plötzlich nach, wonach das Bauelement unter geringem Druck eingesteckt wird. Durch die dabei auftretende plötzliche Entspannung der Schaltungsplatte kann diese ruckartig entgegen der Einsteckrichtung zurückfedern. Hierbei kommt es oft vor, daß andere bereits eingesteckte Bauelemente, z.B. Dioden, Transistoren, Widerstände mit Drahtanschlüssen etc., aus ihren Einstecköffnungen herausfallen. Außerdem garantiert die bekannte Schlitzform keine genaue Einstecklage des Bauelementes.

Mit der vorliegenden Erfindung soll die Aufgabe gelöst werden, plättchenförmige Bauelemente in Steckschlitze von insbesondere gedruckten Schaltungsplatten so einsetzen zu können, daß die vorgenannten Probleme ohne Mehraufwand nicht mehr auftreten und die Bauelemente gegebenenfalls auch rationell, d.h. durch Bestückungsautomaten, in richtiger Lage leicht einsetzbar sind.

Erfindungsgemäß wird diese Aufgabe dadurch gelöst, daß die Länge des Steckschlitzes etwas größer ist als die Breite des Bauelementes bzw. die Breite des Bauelementes im Steckbereich und die Steckschlitzbreite 0,2 bis 0,8 mm, insbesondere 0,3 bis 0,6 mm größer ist als die Dicke des Bauelementes bzw. seines Steckbereichs, daß im Bereich der Schlitzenden an beiden Längsseiten an gegenüberliegenden Stellen nach innen ragende Zungen vorgesehen sind, deren lichte Weite 0,05 bis 0,4 mm, insbesondere 0,1 bis 0,3 mm kleiner ist als die Dicke des Bauelementes und daß die Zungen im Bereich der schrägen Einsteckkanten derart angeordnet sind, daß sie erst ab einer bestimmten Einsetztiefe des Bauelementes mit diesem in Wirkverbindung treten können.

Durch diese Maßnahme rutscht das Bauelement mit dem einzusteckenden Teil leicht bis zu den Zungen in den Steckschlitz. Beim weiteren Einstecken unter mäßigem Druck werden die Zungenenden durch die schrägen Einsteckkanten des Bauelementes abgebogen oder abgebrochen oder abgeschert. Der Übergang zum fixierenden Einstecken erfolgt hierbei nicht mehr sprunghaft sondern je nach Material, Schräge der Einsteckkanten und Wahl der Zungenenden mehr oder weniger sanft. Die eingangs erwähnten Nachteile werden dabei vollkommen beseitigt.

Weitere vorteilhafte Einzelheiten der Erfindung sind nachfolgend anhand der in der Zeichnung veranschaulichten Ausführungsbeispiele beschrieben.

BAU ORIGINAL

Fig. 1    zeigt eine Schaltungsplatte mit einem eingesteckten Bauelement von oben,

Fig. 2    eine Schaltungsplatte ohne Bauelement mit
          unterschiedlichen Zungenausführungen von oben,

Fig. 3    eine Seitenansicht im Schnitt mit einem
          trapezförmigen Bauelement,

Fig. 4a   eine Ansicht von der Schmalseite eines nur
          lose eingesetzten Bauelementes mit aufgeschnittener Schaltungsplatte,

Fig. 4b   die Ansicht von der Breitseite mit aufgeschnittener Schaltungsplatte    und

Fig. 4c   die Ansicht gemäß 4b, jedoch mit in Endlage
          eingestecktem Bauelement.


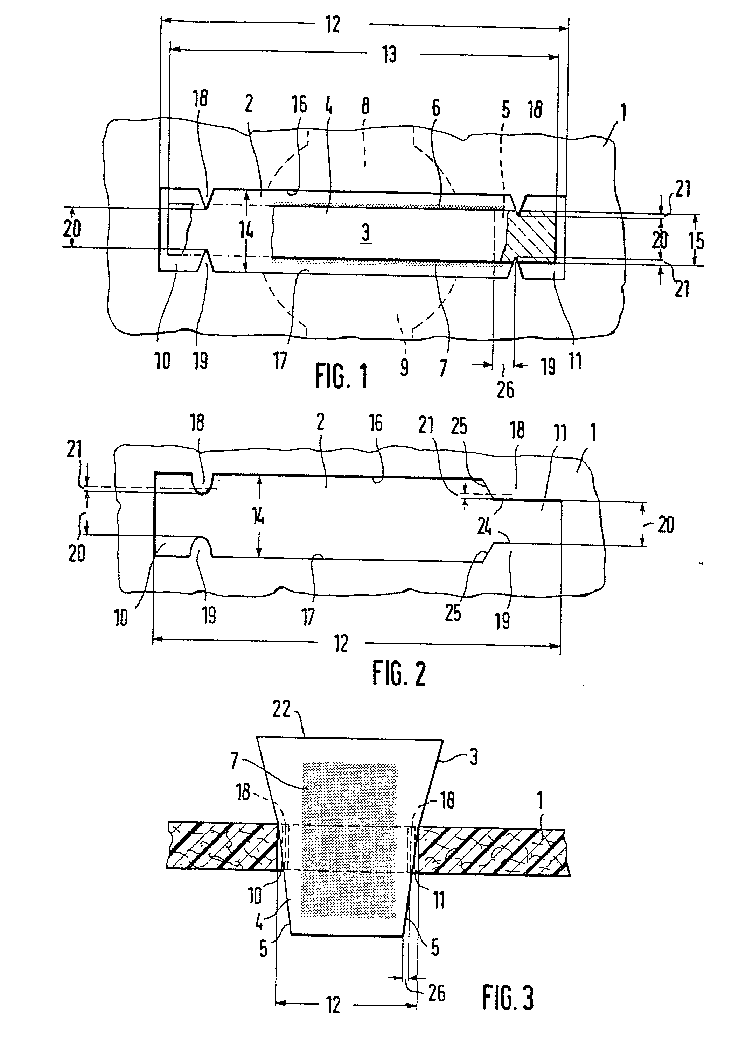

In Fig. 1 ist mit 1 eine gedruckte Schaltungsplatte aus
verformbarem Material wie z.B. Hartpapier, Kunststoff
oder faserverstärktem Kunststoff bezeichnet. Sie ist mit
einem Steckschlitz 2 versehen, in den ein elektrisches
plättchenförmiges Bauelement 3 von Trapez- oder Rechteckform mit seinem Einsteckteil 4 eingesteckt ist. Das Bauelement 3 oder zumindest der Anfang des Steckbereiches 4
ist mit schrägen Einsteckkanten 5 versehen. Eine oder
beide gegenüberliegende Flächen des Bauelementes 3 sind
im Einsteckbereich mit einer leit- und lötfähigen Schicht
6, 7 versehen, die mit Lötaugen 8, 9 der gedruckten
Schaltungsplatte 1 verlötet werden können.

Zum leichten Einstecken und zur Halterung des Bauelementes
3 im Steckschlitz 2 ist die Länge 12 des Steckschlitzes 2
etwas größer als die Breite 13 des Bauelementes 3 bzw. seines Steckbereiches 4 und die Steckschlitzbreite 14 ist
0,2 bis 0,8 mm, insbesondere ca. 0,3 bis 0,6 mm größer als
die Dicke 15 des Bauelementes 3 bzw. als die Dicke des
Bauelementes 3 in seinem Steckbereich 4, wenn dieser z.B.
dünner ist als das übrige Bauelementteil, und im Bereich
der Schlitzenden 10, 11 sind an den Längsseiten 16, 17 jeweils an gegenüberliegenden Stellen nach innen ragende Zungen 18, 19 angeordnet. Die lichte Weite 20 zwischen den Zungenenden 21 ist etwa 0,05 bis 0,4 mm, vorzugsweise 0,1 bis 0,3 mm kleiner als die Dicke 15 des Bauelementes 3 oder seines Steckbereiches 4.

Die Anordnung der in diesem Beispiel spitzwinkeligen Zungen 18, 19 im Endbereich 10 bzw. 11 des Steckschlitzes 2 ist so gewählt, daß sie im Bereich der schrägen Einsteckkanten 5 des Bauelementes 3 liegt, und zwar derart, daß das Bauelement 3 bzw. sein Steckbereich 4 zunächst berührungslos eingesteckt werden kann, z.B. bis zu einer Einsetztiefe 23 von ca. 0,5 mm bis zu einigen mm, und erst dann die Zungen 18, 19 mit den schrägen Einsteckkanten 5 in Berührung kommen. Durch leichten Druck auf die Oberkante 22 des Bauelementes 3 schert und/oder drückt die Einsteckkante 5 die Zungenenden 21 weg und der restliche Teil der Zungen 18, 19 hält das Bauelement 3 in der eingesteckten Lage und Tiefe fest. Gegebenenfalls tritt eine leichte federnde Biegung der Zungen 18, 19 nach unten ein, so daß das Bauelement 3 nach oben nur mit höherer Kraft herausziehbar ist als es eingesteckt wird. Das Bauelement 3 ist damit gegen Herausfallen gesichert, es bleibt in der richtigen Einstecklage und beim Einsetzen können bereits eingesteckte Bauelemente nicht mehr herausfallen.

Beim Ausführungsbeispiel gemäß Fig. 2 ist die linke Seite anstelle der Zungen 18, 19 in Form spitzwinkliger Zähne der Fig. 1 hier als abgerundete Lappen ausgebildet. Diese Ausführung könnte z.B. vorteilhafter sein, wenn das Basismaterial der Schaltungsplatte 1 sehr weich oder spröde ist.

Die rechte Seite der Fig. 2 zeigt Zungen 18, 19, die als Vorsprünge ausgebildet sind, deren Stirnkanten 24 wenigstens annähernd parallel zu den Langsseiten 16 bzw. 17 des
Steckschlitzes 2 verlaufen und gegebenenfalls bis zum
Schlitzende reichen. Die Auflaufkanten 25 bilden zweckmäßig mit den Stirnkanten 24 einen stumpfen Winkel.
Eine derartige Ausführung ist auch bei sehr weichem
oder sprödem Material mit Vorteil anwendbar. Sie sind
jedoch auch dann zweckmäßig, wenn die Einstecktiefe
nicht sehr groß sein soll.

Fig. 3 zeigt ein Ausführungsbeispiel mit einem trapezförmig ausgebildeten plättchenartigen Bauelement 3. Hier
ist der Bereich 26 sichtbar, um den die Zungen 18, 19
bzw. deren mit dem Bauelement 3 in Kraftschluß kommendes
Zungenende 21 zum Schlitzende 10, 11 hin versetzt angeordnet sind, um ein Einsetzen des Bauelementes 3 zu ermöglichen.

Das Einsetzen eines Bauelementes 3 ist in den Fig. 4a
und 4b gezeigt. Hier ist die Einsetztiefe 23 sichtbar. In
diesem Zustand treffen die schrägen Einsteckkanten 5
des Bauelementes 3 gerade von oben auf die Zungenenden 21.

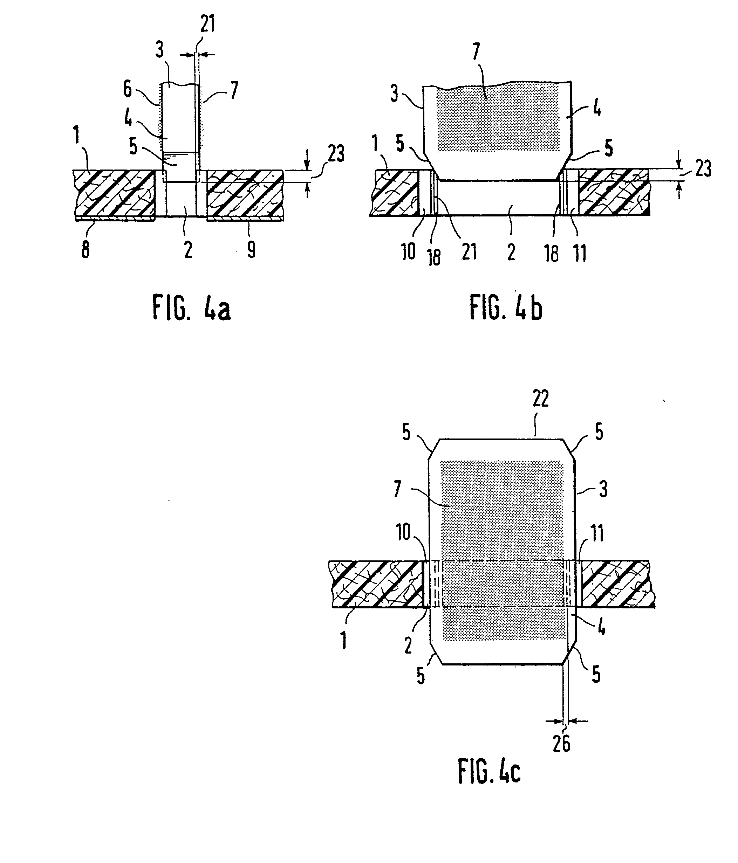

Die Fig. 4c zeigt das Bauelement 3 in eingestecktem Zustand. Hier ist auch, wie in Fig. 4b angedeutet, das
Bauelement 3 als rechteckiges Plättchen ausgebildet.

Dies hat den Vorteil gegenüber der Trapezform, daß die
Herstellungsprozesse derselben rationeller durchführbar
sind. Insbesondere kann der Einfüllvorgang in Fertigungsschablonen vereinfacht werden und beim Bestücken, insbesondere dem automatischen Bestücken von Schaltungsplatten mit diesen Bauelementen, brauchen diese unter
Umständen nicht in eine ganz bestimmte Vorzugsrichtung
gebracht werden.

Patentansprüche

1.  Schaltungsplatte aus verformbarem Material, insbesondere aus Hartpapier oder faserverstärktem organischem Kunststoff, mit wenigstens einem rechteckigen Steckschlitz zum Einstecken und klemmenden Halten von plättchenförmigen Bauelementen mit schrägen Einsteckkanten an den Schmalseiten, dadurch gekennzeichnet, daß die Länge (12) des Steckschlitzes (2) etwas größer ist als die Breite (13) des Bauelementes (3) bzw. die Breite (13) des Bauelementes (3) im Steckbereich (4) und die Steckschlitzbreite (14) 0,2 bis 0,8 mm, insbesondere 0,3 bis 0,6 mm größer ist als die Dicke (15) des Bauelementes (3) bzw. seines Steckbereichs (4), daß im Bereich der Schlitzenden (10, 11) an beiden Längsseiten (16, 17) an gegenüberliegenden Stellen nach innen ragende Zungen (18, 19) vorgesehen sind, deren lichte Weite (20) 0,05 bis 0,4 mm, insbesondere 0,1 bis 0,3 mm kleiner ist als die Dicke (15) des Bauelements (3) bzw. seines Steckbereiches (4) und daß die Zungen (18, 19) im Bereich der schrägen Einsteckkanten (5) derart angeordnet sind, daß sie erst ab einer bestimmten Einsetztiefe (23) des Bauelementes (3) mit diesem in Wirkverbindung treten können.

2.  Schaltungsplatte nach Anspruch 1, dadurch gekennzeichnet, daß die Zungen (18, 19) die Form spitzwinkeliger Zähne aufweisen.

3.  Schaltungsplatte nach Anspruch 1, dadurch gekennzeichnet, daß die Zungen (18, 19) die Form abgerundeter Lappen aufweisen.

4.  Schaltungsplatte nach Anspruch 1, dadurch gekennzeichnet, daß die Zungen (18, 19) die Form von Vorsprüngen mit wenigstens annähernd parallel zur Längsseite (16, 17) des Steckschlitzes (2) verlaufender Stirnkante (24) aufweisen.

FIG. 1

FIG. 2

FIG. 3

0054211

FIG. 4a

FIG. 4b

FIG. 4c